# EUROPEAN PATENT APPLICATION

(11) **EP 4 535 582 A1**
(43) Date of publication of application: **09.04.2025**
(21) Application number: 22944813.9
(22) Date of filing: 31.05.2022
(51) Int. Cl.: H01S 5/12, G02B 6/122, G02B 6/125, H01S 5/026, H01S 5/16, H01S 5/50

(54) **OPTICAL TRANSMITTER**

(71) Applicant: NIPPON TELEGRAPH AND TELEPHONE CORPORATION, Chiyoda-ku, Tokyo 100-8116 (JP)
(72) Inventor: SHINDO, Takahiko, Musashino-shi, Tokyo 180-8585 (JP); KANAZAWA, Shigeru, Musashino-shi, Tokyo 180-8585 (JP); CHIN, Meishin, Musashino-shi, Tokyo 180-8585 (JP)
(74) Representative: TBK
(86) International application number: PCT/JP2022/022135
(87) International publication number: WO 2023/233525

(57) **Abstract**

Provided is an optical transmitter having high manufacturing stability and a high reflection suppression effect. In the optical transmitter, a distributed feedback (DFB) laser having an active region formed as a multiple quantum well that generates an optical gain by current injection and a diffraction grating, an electro-absorption (EA) modulator having an absorption region formed as a multiple quantum well having a composition different from a composition of the DFB laser, a semiconductor amplifier (SOA) having an active region having a same composition as the composition of the DFB laser, a bent waveguide that rotates a light propagation direction by an angle θwg, and a passive waveguide connected to the SOA and including a core having a band gap wavelength shorter than an oscillation wavelength of the DFB laser are monolithically integrated on one substrate. The passive waveguide has a tapered region and a narrow waveguide region. The tapered region converts a width W1 of the passive waveguide connected to the SOA into a width W2 of the narrow waveguide region, and the passive waveguide forms the angle θwg with respect to a normal line to an end surface of the substrate and is in contact with the end surface of the substrate.

## Description

### Technical Field

The present disclosure relates to an optical transmitter and, more particularly, to a semiconductor laser element in which an electro-absorption (EA) optical modulator is integrated on an InP substrate. More specifically, the present disclosure relates to an optical transmitter including an EA modulator, a semiconductor optical amplifier (SOA), and a distributed feedback (DFB) laser.

### Background Art

Network traffic has explosively increased with the spread of video distribution services and an increase in demand for mobile traffic in recent years. In an optical transmission line that supports a network, there has been a trend toward a lower network cost caused by an increase in transmission rate, a reduction in power consumption, and an increase in transmission distance. A semiconductor modulation light source used in a network is also required to achieve high speed and high output while suppressing excessive power consumption.

An electro-absorption modulator integrated DFB (EADFB) laser has been used in a wide range of applications because of its high extinction and excellent chirp characteristics as compared with a directly modulated laser.

There has also been proposed an EADFB laser in which a semiconductor optical amplifier (SOA) is integrated (SOA assisted extended reach EADFB laser: AXEL) (see, for example, Non Patent Literature 1). The AXEL can be used as an optical transmitter in optical communication.

### Citation List

### Non Patent Literature

Non Patent Literature 1: W Kobayashi et al., "Novel approach for chirp and output power compensation applied to a 40-Gbit/s EADFB laser integrated with a short SOA," Opt. Express, Vol. 23, No. 7, pp. 9533-9542, Apr. 2015

### Summary of Invention

It is desired to improve manufacturing stability of the AXEL and a sufficient reflection suppression effect on an end surface of a semiconductor chip on which the AXEL is formed.

The present disclosure has been made in view of such circumstances, and an object thereof is to provide an optical transmitter having high manufacturing stability and a high reflection suppression effect.

In order to achieve the object, an optical transmitter according to an embodiment of the present invention is an optical transmitter, in which a distributed feedback (DFB) laser having an active region formed as a multiple quantum well that generates an optical gain by current injection and a diffraction grating, an electro-absorption (EA) modulator having an absorption region formed as a multiple quantum well having a composition different from a composition of the DFB laser, a semiconductor amplifier (SOA) having an active region having a same composition as the composition of the DFB laser, a bent waveguide that rotates a light propagation direction by an angle θwg, and a passive waveguide connected to the SOA and including a core having a band gap wavelength shorter than an oscillation wavelength of the DFB laser are monolithically integrated on one substrate, in which: the passive waveguide has a tapered region and a narrow waveguide region; the tapered region converts a width W1 of the passive waveguide connected to the SOA into a width W2 of the narrow waveguide region; and the passive waveguide forms the angle θwg with respect to a normal line to an end surface of the substrate and is in contact with the end surface of the substrate.

As described above, according to the embodiment of the present invention, it is possible to provide an optical transmitter having high manufacturing stability and a high reflection suppression effect.

### Brief Description of Drawings

Fig. 1 is a cross-sectional view illustrating a schematic configuration of a general EADFB laser.
Fig. 2 is a cross-sectional view illustrating a schematic configuration of an AXEL.
Fig. 3 is a top view illustrating a schematic configuration of an emitting end surface of an AXEL.
Fig. 4 is a top view illustrating a plurality of semiconductor chips arrayed on a wafer.
Figs. 5(a) and 5(b) are explanatory diagrams of a yield of chips during wafer manufacture.
Fig. 6 is a top view illustrating a schematic configuration of emitting portions and their vicinity of AXELs having a window region.
Fig. 7 shows results of evaluating optical waveform quality of a plurality of modules on which AXELs are mounted.
Figs. 8(a) and 8(b) schematically illustrate a light beam shape in the vicinity of an end surface of a semiconductor chip; Fig. 8(a) is a top view, and Fig. 8(b) is a cross-sectional view.
Figs. 9(a), 9(b), and 9(c) are cross-sectional views illustrating some steps of fabricating a window region.
Fig. 10 is a schematic views illustrating a schematic configuration of an AXEL having a window region formed by embedding regrowth; Fig. 10(a) is a top view, and Figs. 10(b), 10(c), and 10(d) are cross-sectional views.
Fig. 11 shows results of evaluating window region optical waveform quality of a plurality of modules on each of which an AXEL having a window region is mounted.
Fig. 12 illustrates an emitting end and its vicinity at a subsequent stage of a SOA of an AXEL according to an embodiment of the present disclosure.
Fig. 13 illustrates a plurality of adjacent chips arranged on a wafer before being cleaved.
Fig. 14 shows dependency of a mask margin on a width of a narrow waveguide region.
Fig. 15 shows results of evaluating optical losses of a plurality of modules on each of which an AXEL having a narrow waveguide region according to an embodiment of the present disclosure is mounted.
Fig. 16 is an explanatory diagram of reduction in chip size and improvement in a chip yield by an AXEL having a narrow waveguide region according to an embodiment of the present disclosure.
Fig. 17 is a top view illustrating a schematic configuration of an AXEL according to an example.
Fig. 18 schematically illustrates an arrangement example of AXEL chips adopted in an example.
Fig. 19 illustrates a state of a terminal end of a mesa-shaped waveguide in an AXEL manufacturing step; Fig. 19(a) is a cross-sectional view after dry etching processing, and Figs. 19(b) and 19(c) are cross-sectional views after wet etching processing.
Fig. 20 illustrates a schematic configuration of AXEL chips according to an example.
Fig. 21 shows a relationship between a width W3 of a waveguide terminal end and an amount of side etching.
Fig. 22 is a top view illustrating a schematic configuration of a waveguide terminal end and its vicinity in an AXEL chip according to an example.

### Description of Embodiments

Hereinafter, embodiments of the present disclosure will be described in detail with reference to the drawings. The same or similar reference signs denote the same or similar components, and redundant description thereof may be omitted. Numerical values or materials in the following description are merely examples, and the present disclosure can be implemented by using other numerical values or materials without departing from the gist thereof.

[Math. 1]
Further, a substrate orientation [011] in the following description may be a substrate orientation [011]. In the following description, only the substrate orientation [011] will be described, and the description of [011] will be omitted.

Before the description of the embodiments of the present disclosure, an AXEL, which is an EADFB laser in which a SOA is integrated, will be described.

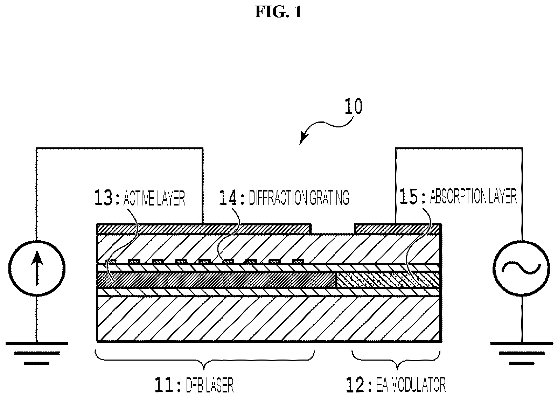

Fig. 1 is a cross-sectional view illustrating a schematic configuration of a general EADFB laser. A general EADFB laser 10 in Fig. 1 has a structure in which a DFB laser 11 and an EA modulator 12 are integrated in the same chip. The DFB laser 11 includes an active layer 13 formed as a multiple quantum well (MQW) and oscillates with a single wavelength by a diffraction grating 14 formed in a resonator. The EA modulator 12 includes a light absorption layer formed as a multiple quantum well (MQW) having a composition different from that of the DFB laser 11 and changes an amount of light absorption by voltage control. The EA modulator 12 is driven under the condition that output light from the DFB laser 11 is transmitted or absorbed to blink light and converts an electrical signal into an optical signal.

The EADFB laser 10 has the following problem: it is difficult to achieve high output because the EA modulator has a large optical loss. The above-described AXEL is proposed as a solution thereof.

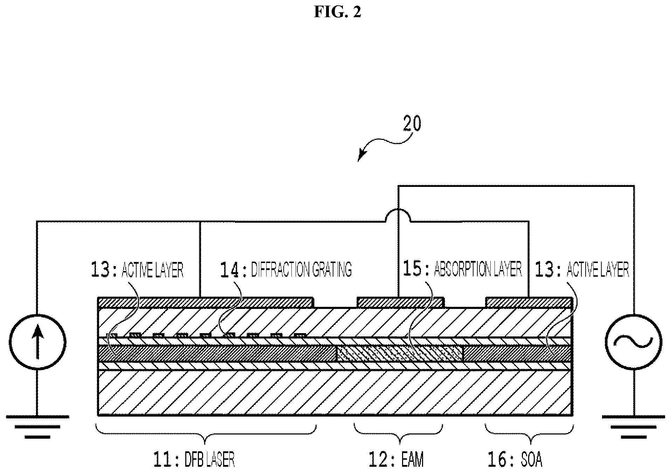

Fig. 2 is a cross-sectional view illustrating a schematic configuration of the AXEL. An AXEL 20 in Fig. 2 can improve output because light from the DFB laser 11 is modulated into signal light by the EA modulator 12, and the signal light is amplified by a SOA 16. The AXEL has an output characteristic that is approximately twice higher than that of the general EADFB laser. Further, the AXEL can operate with high efficiency due to a SOA integration effect, and thus power consumption can be reduced by approximately 40% in a case where the AXEL is driven under an operation condition in which the same optical output as that of the general EADFB laser is obtained. Furthermore, in the AXEL, the SOA 16 and the active layer 13 of the DFB laser 11 are formed to have the same MQW structure. This makes it possible to fabricate the AXEL 20 in the same manufacturing step as that of the conventional EADFB laser 10 without adding a regrowth process for integrating the SOA 16.

The AXEL has the following problem: deterioration in an operation characteristic caused by reflected return light becomes remarkable due to a high optical output characteristic caused by integration of the SOA 16. In an optical transmitter such as a general semiconductor laser, it is known that reflected return light, which is reflected by an end surface of a semiconductor chip to return to the inside of the chip, adversely affects an operation characteristic of a device. Therefore, an anti-reflection (AR) coating is applied to the end surface of the chip in the semiconductor optical transmitter, and thus the reflected return light from the end surface of the chip to the inside is generally suppressed to 0.1% or less. However, in the EADFB laser in which the SOA is integrated (AXEL), even a small amount of reflected return light greatly affects the operation characteristic due to the high output characteristic. If an optical amplification effect by the SOA in the AXEL is +3 dB as compared with the conventional EADFB laser, an average optical output is increased by +3 dB, and at the same time, an intensity of the reflected return light is also increased by 3 dB. Further, because the reflected return light from the end surface of the AXEL is amplified again in the SOA, the intensity of the reflected return light reaching the DFB laser in the AXEL is increased by +6 dB as compared with the EADFB laser. Therefore, as a countermeasure against the reflected return light in the AXEL, a combined structure of a window structure and a bent waveguide is adopted in addition to the AR coating.

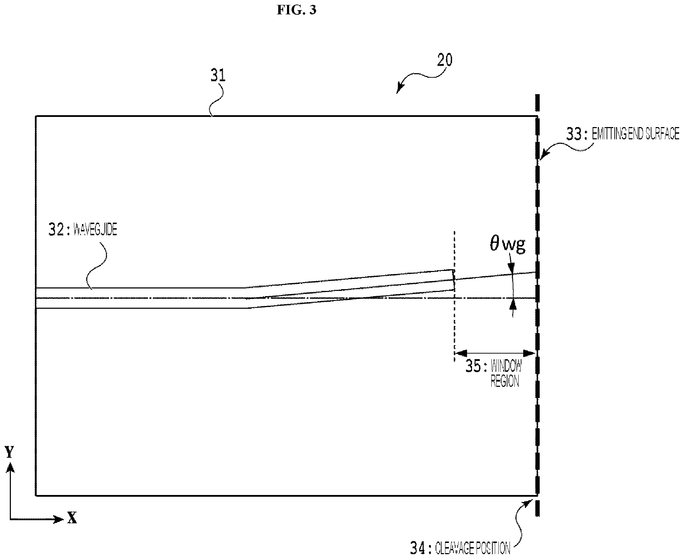

Fig. 3 is a top view illustrating a schematic configuration of an emitting end surface of the AXEL. Fig. 3 illustrates a part of a waveguide 32 connected to the SOA of the chipped AXEL 20. Signal light from the SOA of the AXEL 20 in the semiconductor chip (also simply referred to as a chip in the present specification) 31 is guided by the waveguide 32 and is output from an emitting end surface 33. Normally, an emitting end surface of a semiconductor chip is a crystal plane formed by cleavage, and a waveguide in the semiconductor chip is formed at an angle perpendicular to the emitting end surface. Therefore, light propagating through the waveguide is perpendicularly incident on the emitting surface and is emitted from the semiconductor chip. Meanwhile, in the AXEL 20 of Fig. 3, the waveguide 32 in the semiconductor chip 31 is bent. Signal light guided through the waveguide 32 is incident on the emitting end surface 33 at an angle of incidence θwg. Therefore, light reflected by the emitting end surface 33 is less likely to be coupled to the waveguide 32 again. That is, it is possible to suppress reflected return light from the emitting end surface 33. The angle of incidence θwg of the signal light from the waveguide 32 on the emitting end surface 33 for suppressing reflection is generally 4° to 8°.

In the structure of Fig. 3, the waveguide 32 terminates inside the semiconductor chip 31. The signal light emitted from the waveguide 32 propagates through a bulk semiconductor called a window region 35, then reaches the emitting end surface 33, and is emitted to the outside from the semiconductor chip 31. At this time, the signal light propagates while expanding a beam diameter due to a diffraction effect in the window region 35. This reduces a proportion of a light field that is reflected by the emitting end surface 33 to overlap with the waveguide 32 inside the semiconductor chip 31, thereby further reducing the reflected return light to be coupled to the waveguide 32. The window region 35 is generally fabricated to have a length of approximately 10 µm in a light propagation direction (X direction). The AXEL 20 cannot have a high output characteristic and a high quality transmission characteristic at the same time unless those countermeasures against the reflected return light are sufficiently performed.

As described above, the AXEL adopts the bent waveguide and the window structure in the emitting end surface in order to reduce the reflected return light on the end surface of the chip as much as possible. Here, structural problems thereof will be described.

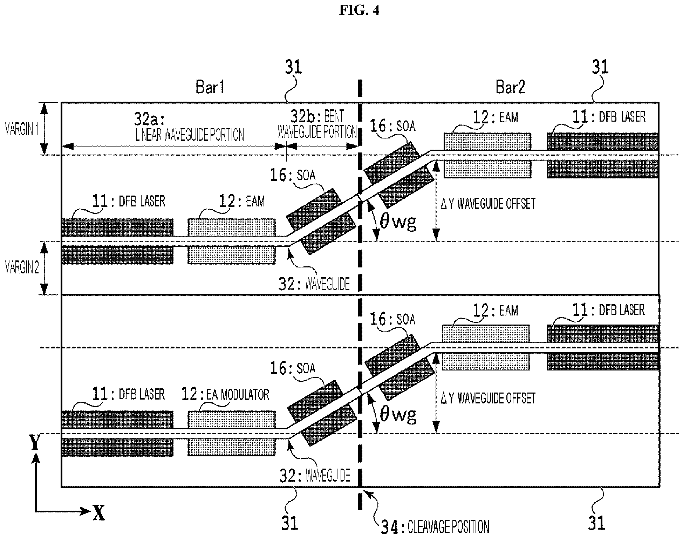

First, a problem occurring when the bent waveguide is adopted will be described with reference to Fig. 4. Fig. 4 is a top view illustrating a plurality of semiconductor chips 31 arrayed in X and Y directions on a wafer. In the present specification, a semiconductor substrate on which the AXEL is formed and which is formed into a chip will also be referred to as an AXEL chip. In Fig. 4, two semiconductor chips 31 in each of which the AXEL having the waveguide 32 is formed face each other in the light propagation direction (X direction). The waveguide 32 has a linear waveguide portion 32a and a bent waveguide portion 32b. Fig. 4 illustrates the AXEL chip having no window region 35.

Normally, in an optical semiconductor device such as a semiconductor laser, a plurality of chips having the same emitting end surface is cleaved in a bar shape to form an emitting end surface. Further, BARs adjacent to each other in the light propagation direction are arranged such that emitting end surfaces thereof face each other, and facing chips are arranged to share the emitting end surfaces formed by cleavage.

As illustrated in Fig. 4, in the plurality of chips 31, the bent waveguide portion 32b is formed to have θwg between an optical axis and the emitting end surface, and the bent waveguide portions 32b in the two adjacent chips 31 facing each other in the X direction are arranged while being connected to each other. That is, the two adjacent chips facing each other are arranged to have the same optical axis. In other words, the two chips are continuously created on the same waveguide. Two adjacent Bar 1 and Bar 2 are separated by cleavage to form the emitting end surface 33 at which the waveguide 32 terminates. In an actual semiconductor chip cleavage step, there is a limit to accuracy of a cleavage position, and a position shift of approximately ±10 µm normally occurs. When the facing chips are arranged to align their optical axes and connect their waveguides as described above, both the chips can have a structure in which the waveguide terminates at the emitting end surface even in a case where an error occurs in the cleavage position. This makes it possible to suppress a decrease in a yield in the cleavage step. However, this arrangement disadvantageously increases the chip size.

The DFB laser 11, the EA modulator 12, and the SOA 16 in the AXEL are formed on the waveguide having the optical axis in a direction perpendicular to the emitting end surface 33 (X direction). In the two facing chips, the optical axes of the DFB lasers 11 do not match and are arranged at positions separated by a distance ΔY in parallel. This ΔY will be referred to as a waveguide offset. As is clear from Fig. 4, the size of the semiconductor chip 31 in the Y direction needs to be equal to or larger than the waveguide offset. Further, an optical element portion such as the DFB laser 11 and a light emitting position on a cleavage end surface (terminal end position of the waveguide 32) are desirably located at the center of the chip. Therefore, the size of the chip in the Y direction is designed to have a sufficient margin with respect to the waveguide offset. The bent waveguide portion 32b of the AXEL normally needs to have a length of at least approximately 400 µm. Further, assuming that the bending angle θwg of the waveguide is 5°, the waveguide offset is ΔY = approximately 70 µm. In this case, in a case where a margin of 100 µm is secured on both sides of the linear waveguide portion 32a of each of the chips 31 in the Bars 1 and 2 (margins 1 and 2 in Fig. 4), a chip width (length in the Y direction) needs to be at least 270 µm. Thus, in the conventional AXEL, it is difficult to reduce the width (size in the Y direction) of the AXEL chip to 250 µm or less in order to secure a sufficient margin (distance) with respect to the waveguide position in the chip from the viewpoints of a manufacturing margin and long-term reliability. Further, the yield of chips during wafer manufacture is also a problem in the conventional AXEL arrangement.

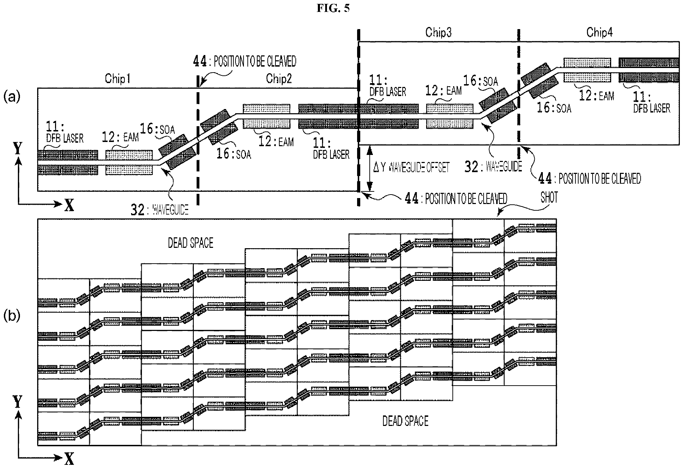

The yield of chips during wafer manufacture will be described with reference to Fig. 5. Fig. 5(a) schematically illustrates an arrangement of four chips (chips 1 to 4) continuously formed on the same waveguide 32 on a semiconductor wafer in an AXEL chip manufacturing process. After a manufacturing step of each element in the chip, each chip is separated by the cleavage step as described above. The chips 1 and 2 are arranged and connected to face each other such that the SOAs 16 that obtain an optical output are close to each other, and the chips 2 and 3 are connected such that the DFB lasers are adjacent to each other. As described above, the emitting end surface of the chip and the terminal end of the waveguide are determined by cleavage. Therefore, the chips adjacent in the x direction are arranged while the waveguides 32 are being connected in consideration of a position shift error of the cleavage in advance. The same applies not only to SOA sides (a boundary between the chip 1 and the chip 2) which are the emitting end sides, but also to the DFB laser sides (a boundary between the chip 2 and the chip 3).

Here, a position shift in the Y direction occurs between the chip 2 and the chip 3 due to the above-described waveguide offset. Only four chips continuously arranged in the X direction are illustrated in Fig. 5(a), but, on an actual wafer, ten or more chips are formed on the same continuous waveguide 32. Therefore, as the number of continuous chips increases, the position shift in the Y direction caused by the waveguide offset accumulates. In a case where ten chips are collectively arranged on a wafer, the shift in the Y direction between the chip 1 and the chip 10 reaches 400 µm assuming that the waveguide offset ΔY is 40 µm. Such the position shift on the wafer adversely affects a chip arrangement.

Fig. 5(b) is a schematic view in a case where 10 × 10 AXEL chips are manufactured while being arranged on a wafer. In a normal optical semiconductor manufacturing process, a rectangular (or square) basic unit in which a plurality of chips is arranged, which is called a shot, is arranged on a wafer in a divided manner. As illustrated in Fig. 5(b), in a case where the waveguide offset occurs, a dead zone (margin) where no chip can be arranged is generated in a shot. Therefore, the number of chips manufactured in the same wafer decreases, which inevitably reduces the yield. In Fig. 5(b), when the length (length in the X direction) of the AXEL chip is 1,000 µm, the chip width (length in the Y direction) is 300 µm, and the waveguide offset is 70 µm, the dead zone is 700,000 µm² in the shot. Because the size of the AXEL chip is 300,000 µm², this reduces the yield of approximately 2 to 3% of a whole.

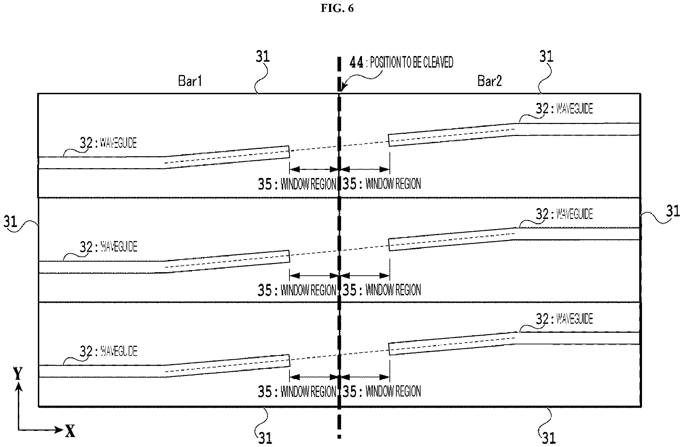

Next, a problem occurring when the window region is adopted will be described with reference to Fig. 6. Fig. 6 is a top view illustrating a schematic configuration of emitting portions and their vicinity of AXELs having the window region. Fig. 6 illustrates adjacent chips in the same bar (Bar 1) and adjacent chips in a facing bar (Bar 2) such that an arrangement in a wafer can be understood. As described above with reference to Fig. 4, also in the AXELs having the window region in Fig. 6, the optical axis of the waveguide 32 at the emitting end is arranged to match with the optical axis of the waveguide 32 of the facing chip.

Each of the two facing chips has the window region 35 and has a terminal end of the waveguide 32 at a position separated from a position 44 to be cleaved by the length (length in the X direction) of the window region 35. A general length of the window region is designed to be approximately 10 µm. As described above, a position shift error of approximately ±10 µm occurs in the cleavage step. Therefore, in a case where the error of the cleavage position is 10 µm or more, the window region 35 in any one of the two bars in Fig. 6 disappears, which cannot obtain a sufficient reflection suppression effect.

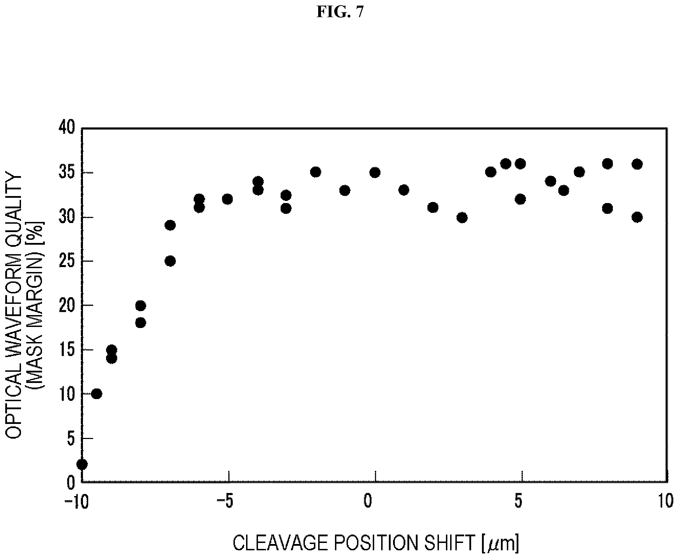

Fig. 7 shows results of evaluating optical waveform quality of a plurality of modules on which AXELs manufactured in the same step are mounted. Here, all AXEL chips have the same structure having an oscillation wavelength in a 1.3 µm band and are different only in the length of the window region due to a manufacturing error. The length of the window region was measured in advance for each chip, and then each chip was mounted on a general butterfly semiconductor module including a two-lens system. A high frequency connector is also mounted on the butterfly package, and each fabricated module was modulated with a 25 Gbit/s NRZ signal to evaluate an optical waveform (EYE waveform). The vertical axis in Fig. 7 represents an index called a mask margin indicating quality of the optical waveform, and the larger the margin, the clearer an opening of an eye. The horizontal axis in Fig. 7 represents an amount of shift of the length of the window region of each manufactured AXEL chip from a designed value of the length of the window region which is 10 µm. It can be confirmed that the mask margin tends to deteriorate as the length of the window region decreases. It is considered that this is because, as the length of the window region decreases, an intensity of return light reflected from the end surface of the chip to the inside of the chip increases, which causes instability of operation of the AXEL. It can be seen from Fig. 7 that the length of the window region needs to be at least 5 µm or more. Meanwhile, in a case where the window region 35 is too long, the characteristics of the AXEL are adversely affected.

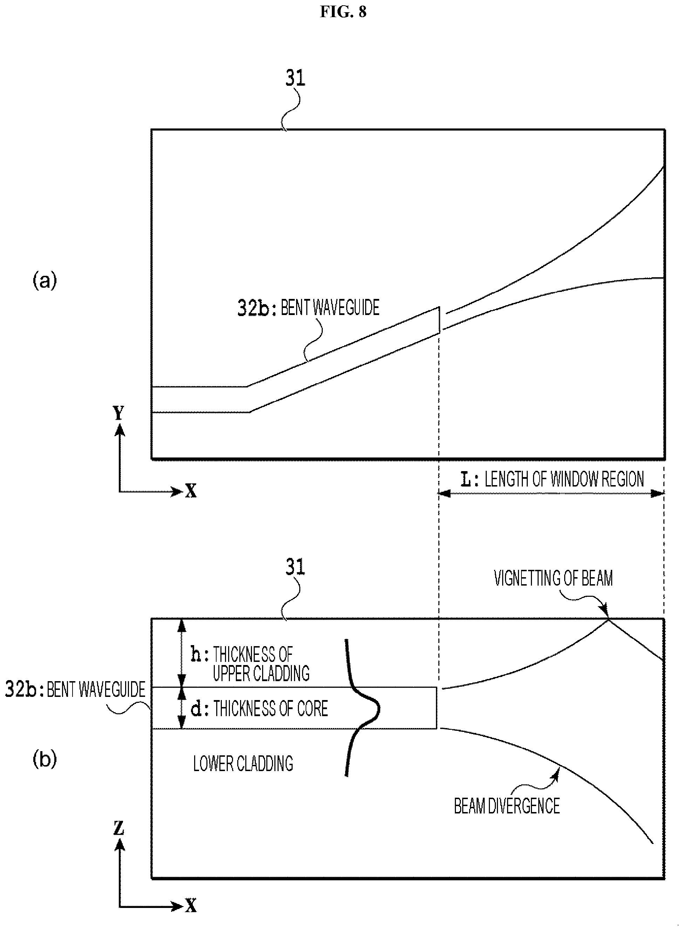

Fig. 8 schematically illustrates a light beam shape in the vicinity of the end surface in a case where a length L of the window region 35 is longer than the design due to a manufacturing error of the cleavage position 44. Fig. 8(a) is a top view, and Fig. 8(b) is a cross-sectional view. In communication wavelength bands of a 1.55 µm band and a 1.3 µm band, a core layer has a thickness of approximately 200 nm to 300 nm. In an InP-based optical semiconductor device, optical confinement in a waveguide perpendicular direction (Z direction) is normally stronger than that in waveguide horizontal directions (XY directions). Therefore, a beam divergence angle in the perpendicular direction in the window region 35 is larger than a beam divergence angle in the horizontal direction. Thus, in a case where the length of the window region is long, an upper end of a beam reaches an interface between a cladding layer and the outside of the semiconductor (air or electrode) in the window region, which causes a defect (vignetting) or optical loss in the beam shape (Fig. 8(b)). In the general InP-based optical semiconductor device, the cladding layer above the waveguide is formed by regrowth, and the upper cladding layer has a thickness of approximately 2 µm. In a case where the window structure is provided, it is necessary to design the thickness of the cladding layer above the core layer in consideration of beam divergence caused by a diffraction effect of a light beam.

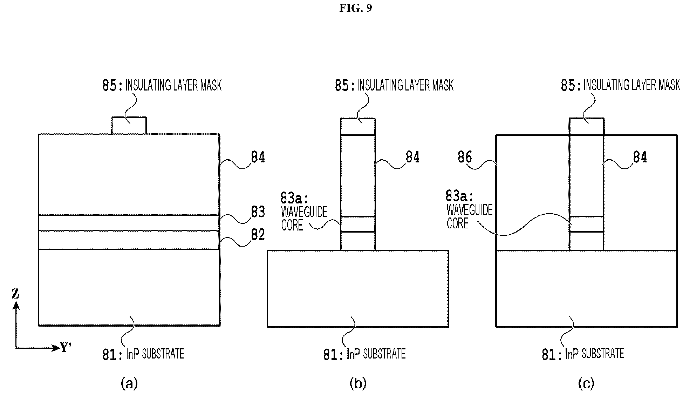

An InP thickness of the window region 35 tends to be thinner than the thickness of the upper cladding in the waveguide portion, which tends to affect a light field in particular. The reason therefor will be described with reference to Fig. 9. As described above, the normal window region 35 is an InP region where the waveguide terminates. InP in the window region 35 is formed at the same time as an upper cladding layer growth step or an embedding growth step. Here, a case where the window region is formed during embedding growth will be described. Fig. 9 is cross-sectional views illustrating some steps of fabricating an AXEL having a buried heterostructure (BH structure). The DFB laser 11, the EA modulator 12, and the SOA 16 have a common buried structure waveguide. As illustrated in Fig. 9(a), first, an insulating film is formed on a surface of a lower cladding layer, a core layer 83, and an upper cladding layer 84 laminated on an InP substrate 81 and is then patterned to form an insulating layer mask 85 having a waveguide shape. Thereafter, as illustrated in Fig. 9(b), a mesa formation step is performed by a dry or wet etching process to form a waveguide including a waveguide core 83a. Subsequently, as illustrated in Fig. 9(c), an InP layer 86 serving as a current blocking layer is regrown to embed the waveguide, and thereafter the insulating layer mask 85 is removed. Thus, the BH structure is completed. The window region 35 described above is also formed at the same time when the BH structure is fabricated.

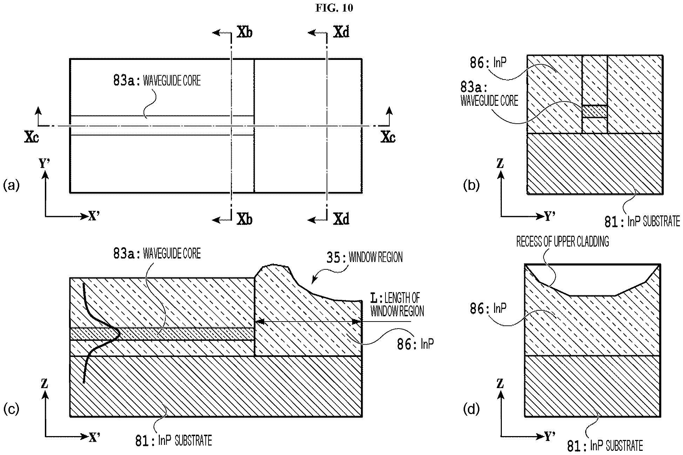

Fig. 10 is a schematic views illustrating a schematic configuration of the AXEL having the window region formed by embedding regrowth. Fig. 10(a) is a schematic view of the window region of the AXEL as viewed from a direction of a substrate upper surface. Fig. 10(b) is a cross-sectional view of the waveguide of the AXEL, Fig. 10(c) is a cross-sectional view of the waveguide of light, and Fig. 10(d) is a cross-sectional view of the window region. In order to simplify the description here, Fig. 10 illustrates a linear waveguide having no bent waveguide portion. As illustrated in Fig. 10(b), the InP 86 serving as the current blocking layer is formed on both sides of the mesa-shaped waveguide by embedding regrowth, and the waveguide core 83a is embedded in the InP 86. Further, as illustrated in Figs. 10(c) and 10(d), a portion to be the window region is etched at the same time when the mesa shape of the waveguide is fabricated, and the same InP layer as the current blocking layer InP is embedded in the embedding regrowth step.

In normal embedding regrowth, a thickness of the InP layer to be regrown is set depending on a height of the mesa-shaped waveguide such that the waveguide is completely embedded. This is because, if the InP layer to be subjected to embedding regrowth is made too thick as compared with the waveguide, the InP layer overlies and is deposited on the insulating layer mask 85 in Fig. 9(c). Meanwhile, as illustrated in the top view of Fig. 10(a), the window region is a portion where the mesa shape terminates, and thus an area of an opening to be embedded at the time of regrowth is relatively wider than those of other portions. Therefore, in a case where the mesa-shaped waveguide and the window region are simultaneously embedded in InP by regrowth, the InP thickness of the window region is partially thinner than that of the mesa-shaped waveguide as illustrated in Fig. 10(c). As described above, the light field propagates while spreading in the window region due to a diffraction phenomenon. Therefore, in a case where the InP film thickness is thin, the light field tends to come into contact with an upper interface with air, which tends to cause an optical loss.

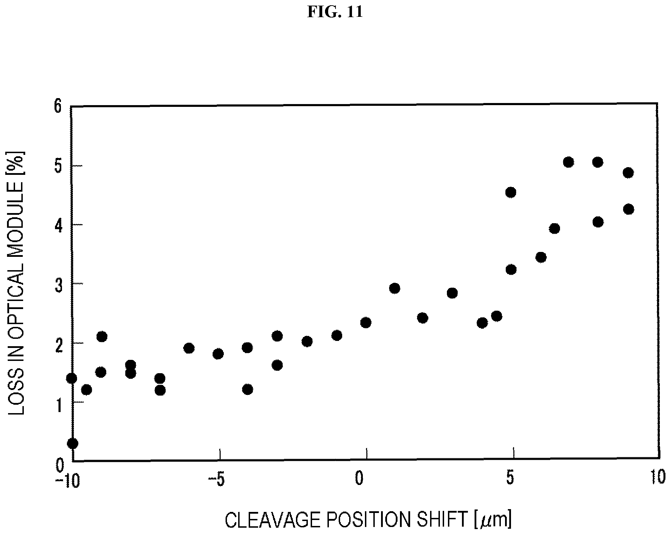

Fig. 11 shows results of fabricating a plurality of modules on each of which an AXEL having a window region fabricated by a normal embedding regrowth step is mounted and evaluating a relationship between optical losses in the modules and variations in the length of the window region. The evaluation results here were obtained by using the same modules as those used for the data shown in Fig. 7. As described above, each module includes an AXEL chip having the same structure, and the designed value of the length of the window region is 10 µm. Before each AXEL chip was mounted on the module, an optical output characteristic thereof was evaluated by using a large-diameter photodetector. Thereafter, the AXEL chip was mounted on the module and then was coupled to an optical fiber to evaluate a light intensity, and thus an optical loss caused by mounting on the module was estimated. The module used here includes a two-lens system, and mounting on the module was performed in an active alignment step. As is clear from Fig. 11, it can be confirmed that the loss inside the module tends to increase as the length of the window region increases. This is because, when the length of the window region increased, an upper end of an emitted beam reached a boundary between the cladding layer and the outside of the chip, which caused a defect in the beam shape, thereby reducing coupling efficiency to the optical fiber. In order to create a stable optical module in which the optical loss in the module is suppressed to 3.0 dB or less, the length of the window region of the AXEL chip needs to be 15 µm or less, that is, the amount of shift of the cleavage position needs to be 5 µm or less. However, in an actual semiconductor chip cleavage step, a cleavage position error of approximately ±10 µm generally occurs. In manufacturing an optical transmitter having sufficient characteristics, a sufficient margin cannot be provided in an AXEL having a window structure when an emitting end surface is formed by cleavage. Thus, a certain number of defective products (chips in which the length of the window region deviates from an allowable value) are always generated due to the manufacturing error of the cleavage position, which reduces a manufacturing yield.

According to an embodiment of the present disclosure, it is possible to provide an AXEL, i.e., an optical transmitter having high manufacturing stability and a high reflection suppression effect. Hereinafter, an AXEL according to the embodiment of the present disclosure will be described.

### (Embodiment)

As described above, a light beam propagates while spreading by diffraction in a window region. Thus, even in a case where light is reflected by an end surface, it is possible to reduce a proportion of a light field distribution coupled to a waveguide again, thereby reducing an amount of return light. The present disclosure enlarges a light beam shape by narrowing a width of the waveguide by tapering. **In** principle, in a case where the width of the waveguide is sufficiently small, light is cut off and thus is radiated without being confined in the waveguide. **In** this state, the light beam propagates while spreading, and thus it is possible to obtain the same reflection suppression effect as that of the window region. However, it is difficult to stably manufacture a waveguide having a narrow width in which propagation light is cut off in the communication wavelength band (1.3 µm or 1.55 µm). In the present disclosure, it is not always necessary to use a waveguide having a narrow width that satisfies a cut-off condition, and a sufficient effect can be exerted by fabricating a waveguide having a width that sufficiently increases a beam diameter of guided light within a range of a manufacturing margin.

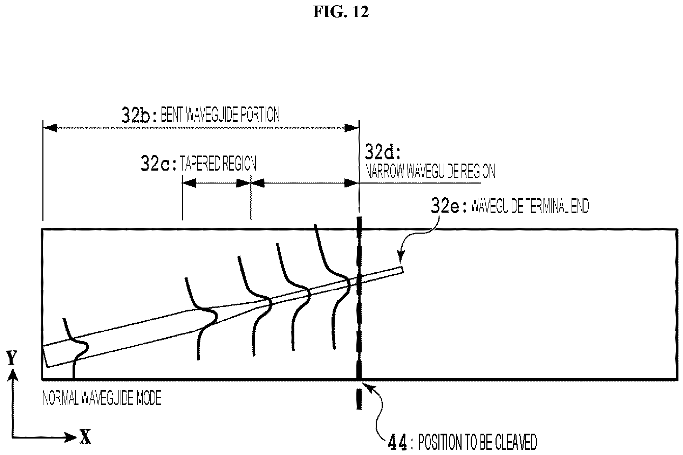

A state thereof is illustrated in Fig. 12. Fig. 12 illustrates an emitting end and its vicinity at a subsequent stage of a SOA of an AXEL according to the embodiment of the present disclosure. In the present disclosure, a tapered region 32c and a narrow waveguide region 32d having a narrowed waveguide width are provided before the emitting end of the bent waveguide portion 32b of the waveguide 32 through which light from the SOA is guided. The narrow waveguide region 32d has a certain length and is arranged beyond the designed position 44 to be cleaved. The narrow waveguide region 32d has a sufficient length for the position shift error of the cleavage process. Therefore, even in a case where the cleavage position is shifted, the end surface is always formed in the narrow waveguide region 32d, which does not affect quality of an emitted beam. Further, a waveguide terminal end 32e is arranged outside the position to be cleaved, that is, outside the chip. With such an arrangement, propagation light is not affected by the reduction in the film thickness of the InP 86 at the waveguide terminal end 32e in the window region and the deterioration in surface flatness described above with reference to Fig. 10.

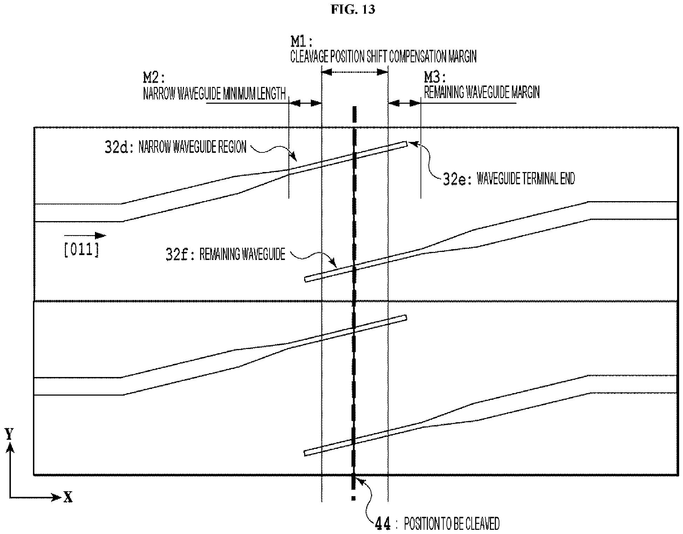

A length necessary for the narrow waveguide region will be described with reference to Fig. 13. As described above, the position shift error of approximately ±10 µm occurs in the cleavage step. Therefore, the narrow waveguide region 32d needs to have a sufficient length of 20 µm or more to compensate for the error (M1 in Fig. 13). Further, in order to sufficiently obtain the reflection suppression effect, the narrow waveguide region 32d following the tapered region 32c needs to remain at least 5 µm or more (M2 in Fig. 13). Furthermore, it is necessary to secure approximately 5 µm as a margin of a remaining waveguide 32f remaining in an adjacent chip when the cleavage position shift occurs (M3 in Fig. 13). From the above points, the length of the narrow waveguide region 32d needs to be at least approximately 30 µm. In this case, considering the above-described cleavage position error, in the cleaved AXEL chip, the length of the narrow waveguide region 32d is 5 µm to 25 µm, and the length of the remaining waveguide 32f including the waveguide terminal end 32e in the adjacent chip is 5 µm to 15 µm.

Further, when an arrangement of the waveguides 32 is adjusted between the adjacent chips, it is possible to achieve an arrangement having no waveguide offset. Fig. 13 illustrates a plurality of adjacent chips arranged on a wafer before being cleaved. In the present disclosure, the waveguide terminal end 32e is arranged outside the chip. That is, the waveguide terminal end 32e is arranged in the facing adjacent chip. Therefore, by using the waveguide offset, the waveguide terminal end 32e is arranged at a position sufficiently away from the optical axis propagating in each chip, and thus the waveguide terminal end 32e does not affect guided light. Accordingly, the waveguide terminal end 32e of the remaining waveguide 32f of the chip adjacent on the wafer remains inside the cleaved chip. The waveguide terminal end 32e of the remaining waveguide 32f does not affect a chip operation at all.

When the arrangement of Fig. 13 is adopted, limitation on the chip size due to the waveguide offset is relaxed. That is, the waveguides are arranged without matching the optical axes of the facing chips, which makes it possible to reduce the chip size.

By adopting the above-described narrow waveguide region 32d, a sufficient reflection suppression effect can be obtained. Here, first, AXEL chips whose narrow waveguide regions 32d have different widths W perpendicular to the light propagation direction were fabricated, and influences of reflected return light were evaluated. As in the description made with reference to Fig. 7, a butterfly module including a 1.3 µm wavelength band AXEL was manufactured, and an influence of an amount of return light was evaluated based on waveform quality of a 25 Gbit/s optical waveform. For the evaluation, AXEL chips whose narrow waveguide regions have different widths W were used. The AXEL chips have the same structure except for the width W of the narrow waveguide region.

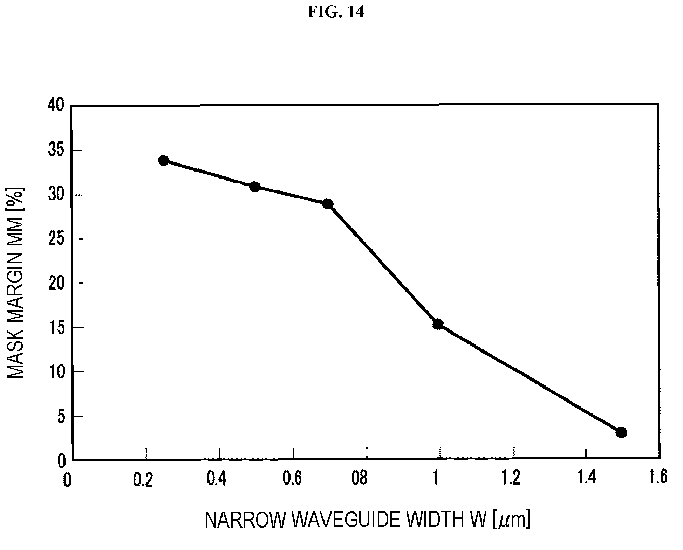

Fig. 14 shows dependency of an evaluated mask margin on the width of the narrow waveguide region. The mask margin is an index indicating waveform quality of propagation light. The waveform quality of the propagation light is higher as a value of the mask margin increases. The evaluation was performed while the width W of the mesa-shaped narrow waveguide region was changed from 0.25 µm to 1.5 µm. Here, when W = 1.5 µm holds, a chip is a normal AXEL whose waveguide has a certain width, that is, a chip having the same width toward the end surface without being tapered near the emitting end of the waveguide. As is clear from Fig. 14, end surface reflection is suppressed as the width W of the narrow waveguide region at the emitting end is reduced, thereby improving the waveform quality. When the width W of the narrow waveguide region is 0.7 µm or less, the mask margin of 30% or more can be secured, which is a practically sufficient reflection suppression effect. However, when the narrow waveguide region has the width W = 0.25 µm, stable manufacturing is difficult in a photolithography step that is a general optical semiconductor device manufacturing process. As a structure that achieves both manufacturing stability and a sufficient reflection suppression effect, the narrow waveguide region is most effective when the width W is approximately 0.4 to 0.8 µm.

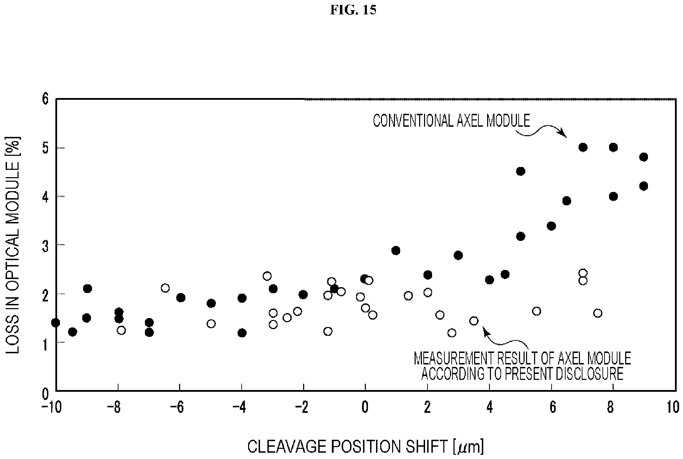

Next, an influence of the cleavage position shift in the AXEL having the narrow waveguide region according to the present disclosure on a chip characteristic was evaluated. Fig. 15 shows results of evaluating optical losses of a plurality of modules on each of which the AXEL chip fabricated in a normal cleavage step is mounted. Here, the width W of the narrow waveguide region in the AXEL chip was 0.5 µm. Data of conventional AXELs shown in Fig. 15 is the same as the data shown in Fig. 11. Content of the evaluation is the same as that described with reference to Fig. 11, that is, the optical loss in the module was calculated from a change in optical output before and after modularization. There is a concern that the loss increases when beam vignetting or the like occurs in an upper part of the cladding layer described above. **In** Fig. 15, the optical loss increases as the cleavage position shift increases in the conventional AXEL chip, whereas, in the AXELs having the narrow waveguide region according to the present disclosure, the optical losses have a substantially constant value regardless of the cleavage position shift and are mainly less than 2.5 dB. From the above results, it was confirmed that variations in chip performance caused by the cleavage position shift, which have conventionally been a problem, were significantly suppressed by introducing the narrow waveguide region of the present disclosure.

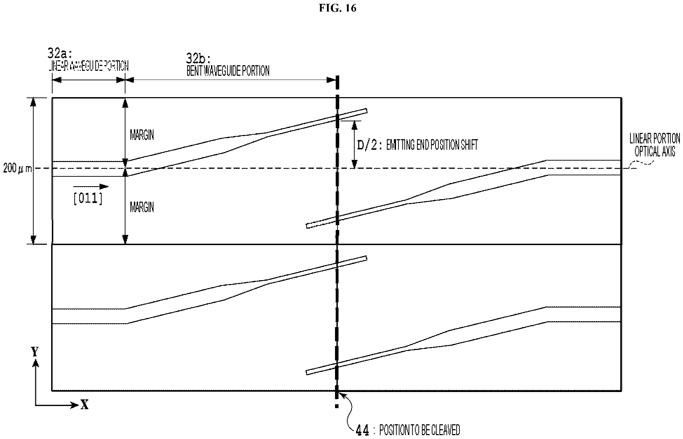

The AXEL having the narrow waveguide region of the present disclosure has effects of reduction in the chip size and improvement in the chip yield during wafer manufacture. Fig. 16 is an explanatory diagram of reduction in the chip size and improvement in the chip yield by the AXEL having the narrow waveguide region. As illustrated in Fig. 16, the linear waveguide portion 32a of the waveguide 32 of the AXEL can be arranged at the center of the chip in the Y direction. Therefore, even in a case where the length of the chip in the Y direction is reduced, a sufficient margin can be secured on both sides of the waveguide. When the size of the chip in the Y direction is 200 µm, and the linear waveguide portion 32a is arranged at the center of the chip, a sufficient margin of 100 µm is secured on both upper and lower sides of the waveguide. When the angle θwg between the optical axis of the bent waveguide portion 32b and a normal line (X direction) to a cleavage surface (end surface) is 5°, and the length of the bent waveguide portion 32b is 400 µm, a position shift of the emitting end of the chip is approximately 35 µm, which is a sufficiently allowable arrangement in manufacturing.

In Fig. 16, the linear waveguide portions 32a of the adjacent chips facing each other match their optical axes. Thus, the waveguide offset ΔY in the Y direction can be set to zero. This makes it possible to solve the problem of the chip yield caused by the waveguide offset described with reference to Fig. 5. In a general AXEL chip, the length of the bent waveguide portion 32b in Fig. 16 is approximately 150 µm to 500 µm. Further, the angle θwg between the optical axis of the general bent waveguide portion 32b and the normal line to the cleavage surface (end surface) is 4° to 8° as described above. Therefore, assuming the angle θwg = 4°, a shift D/2 of an emitting position in Fig. 16 is 10 µm < D/2 < 35 µm. Assuming the angle θwg = 8°, the shift is 21 µm < D/2 < 70 µm. Therefore, the narrow waveguide regions 32d of the adjacent AXEL chips are separated by the distance D on the cleavage surface, and D is 10 µm < D < 140 µm. However, in actual use, the surface flatness of the waveguide terminal end 32e decreases at the time of regrowth as described above, and thus it is necessary to maintain the distance of at least 30 µm from the bent waveguide portion 32b through which light is guided. Therefore, 30 µm < D < 140 µm is desirable.

### (Example 1)

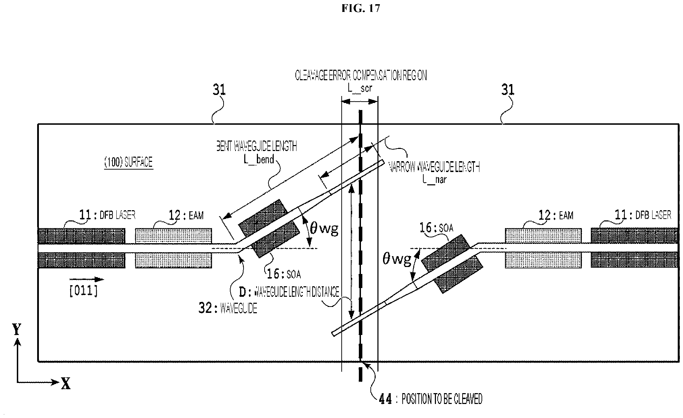

An AXEL of Example 1 will be described with reference to Fig. 17. This example achieves an optical transmitter capable of generating a 25 Gbit/s modulation signal, in which a modulated optical output is increased to 9 dBm or more in order to support a high loss budget system.

Fig. 17 is a top view illustrating a schematic configuration of the AXEL according to this example. The semiconductor chip 31 in Fig. 17 includes the waveguide 32, the DFB laser 11, the EA modulator 12, and the SOA 16 connected by the waveguide 32. As described above, the waveguide 32 has a bent waveguide portion. The bent waveguide portion has a tapered region and a narrow waveguide region. The semiconductor chip 31 is an AXEL chip in which the DFB laser 11, the EA modulator 12, and the SOA 16 are monolithically integrated and forms an optical transmitter. For easy understanding of an emitting end surface formation step by cleavage, Fig. 17 also illustrates another AXEL chip (semiconductor chip 31) adjacent on a wafer.

In the optical transmitter (semiconductor chip 31) of this example, the length of the DFB laser 11 (length along the waveguide 32, the same applies hereinafter) is 300 µm, the length of the EA modulator 12 is 150 µm, and the length of the SOA 16 is 200 µm. The waveguide 32 adopts a buried heterostructure using semi-insulating InP capable of obtaining a high heat dissipation effect and a current blocking effect. As described above, in the AXEL chip of this example, the tapered region 32c and the narrow waveguide region 32d are provided in the bent waveguide portion 32b in order to obtain a sufficient reflection suppression effect. The narrow waveguide region 32d is positioned in the vicinity of the emitting end surface. The AXEL chip is formed on an InP substrate (100) surface, and the DFB laser 11 is arranged to output light in a direction of a substrate orientation [011]. Light from the DFB laser 11 passes through the EA modulator 12 having the same optical axis as the DFB laser 11, then changes its propagation direction in the bent waveguide portion so as to have the angle θwg with respect to the crystal orientation [011], and is incident on the SOA 16. The light emitted from the SOA 16 is converted into the width W of the narrow waveguide region in the tapered region while maintaining the angle θwg. The light propagated through the narrow waveguide region passes through the position 44 to be cleaved and then terminates inside the adjacent chip 31. Here, the angle θwg is set to 5° as a bending angle at which a sufficient reflection suppression effect can be obtained. Further, in order to obtain a sufficient reflection suppression effect, the width W of the narrow waveguide region is set to 0.5 µm which is a range in which stable manufacturing can be performed in a semiconductor processing process.

Under this condition, the narrow waveguide region does not satisfy the cut-off condition. Therefore, the light propagates through the narrow waveguide region without being radiated. Further, the two AXEL chips adjacent in the X direction face each other. In the two AXEL chips, the linear waveguide portions in each of which the DFB laser 11 and the EA modulator 12 are formed are arranged in parallel so as to have the matched optical axes. The bent waveguide portions of the two AXEL chips are arranged in parallel and are apart by the distance D on the position to be cleaved. Here, a length L_bend of the bent waveguide portion of the AXEL chip is 400 µm. Therefore, the waveguide distance D is 70 µm. The two AXEL chips are separated by the cleavage step. As described above, the position shift error of approximately ±10 µm normally occurs in the cleavage step. Therefore, a final light emitting position of the chip is determined when the cleavage step is completed.

In order to obtain a sufficient reflection suppression effect, it is necessary to secure 5 µm or more as the length of the narrow waveguide region following the tapered region in the AXEL chip (M2 in Fig. 13). In consideration of the position shift error in the cleavage step, it is necessary to secure 20 µm or more as a cleavage error compensation region L_scr (M1 in Fig. 13) and to secure 5 µm or more as the length of the remaining waveguide in the adjacent AXEL chip (M3 in Fig. 13). Therefore, in this example, the narrow waveguide is designed to have a length L_nar of 30 µm. When the position shift in the cleavage step is zero, the narrow waveguide portion of 15 µm remains in the AXEL chip. Even in a case where the cleavage position shift occurs and the narrow waveguide region is reduced, the narrow waveguide region of 5 µm or more remains in the chip as long as the cleavage error falls within the range of ±10 µm. Meanwhile, even in a case where the narrow waveguide region is increased due to the cleavage position shift, the length of the narrow waveguide region in the chip is 25 µm or less, and the length of the remaining waveguide remaining in the facing AXEL chip is always 5 µm or more.

Next, a fabrication process of the optical transmitter (semiconductor chip 31) of this example will be described. The semiconductor chip 31 is fabricated by using an initial substrate in which a lower separated confinement heterostructure (SCH) layer, an active layer (MQW 1) serving as a multiple quantum well layer, and an upper SCH layer have been sequentially grown on the n-InP substrate (100) surface. The multiple quantum well layer has an optical gain in an oscillation wavelength 1.3 µm band. The multiple quantum well includes six quantum well layers. The initial substrate has a structure optimized for high efficiency operation of the DFB laser 11.

First, portions to be the DFB laser 11 and the SOA 16 are left, and the other active layers are selectively etched. Then, a multiple quantum well layer (MQW 2) is grown in a portion to be the EA modulator 12 by butt-joint regrowth. The DFB laser 11, the EA modulator 12, and the SOA 16 are arranged such that light propagates in this order. The SOA 16 uses a layer structure of a core layer formed on the initial substrate as it is. Therefore, the layer structure of the SOA 16 is the same as the layer structure of the DFB laser 11. Finally, a difference in the layer structure between the DFB laser 11 and the SOA 16 is only the presence or absence of a diffraction grating. This makes it possible to achieve manufacturing at low cost by suppressing the number of times of regrowth while having a structure in which a plurality of regions is integrated.

Next, a region of a boundary between the portion to be the DFB laser 11 and the portion to be the EA modulator 12, a region of a boundary between the portion to be the EA modulator 12 and the portion to be the SOA 16, and a region from a terminal end of a region of the portion to be the SOA 16 to the emitting end surface are selectively etched again and are subjected to butt-joint regrowth, thereby growing a bulk semiconductor as a core layer of a passive region. The core layer of the passive region has a band gap wavelength shorter than the oscillation wavelength of the DFB laser. In the present specification, a waveguide having the passive region connected to the terminal end of the region of the portion to be the SOA 16 is also referred to as a passive waveguide.

Subsequently, the diffraction grating 14 (not illustrated) which operates in the oscillation wavelength 1.3 µm band is formed in the portion to be the DFB laser 11. The diffraction grating 14 is configured such that a resonator of the DFB laser 11 outputs light in the direction of the substrate orientation [011]. Thereafter, a p-InP cladding layer and a contact layer are grown on the entire surface of the semiconductor chip 31 again by regrowth. Next, a mesa structure is formed in a portion to be the waveguide 32. The DFB laser 11, the EA modulator 12, and the SOA 16 have a waveguide width of 1.5 µm, which is the same as that of a general semiconductor device. In this step, the tapered region, the narrow waveguide region, and the waveguide terminal end of the bent waveguide portion are also collectively created. The insulating layer mask 85 is formed in the portion to be the waveguide 32, and the mesa structure is formed by dry etching.

Next, the mesa structure is embedded in the InP 86 by embedding regrowth while the insulating layer mask is left. In the embedding regrowth, an amount of growth of InP is adjusted to completely embed the waveguide 32 having the mesa structure. When the amount of growth of semi-insulating InP is too small, a current blocking effect is not sufficiently exerted, and a current is not efficiently injected into the DFB laser 11 and the SOA 16. Thus, sufficient characteristics cannot be obtained. Meanwhile, in a case where the amount of growth of semi-insulating InP is too large, the regrown InP overlies an insulating film on the waveguide 32, that is, abnormal growth occurs. This makes it difficult to form electrodes of the DFB laser 11 and the SOA 16. Therefore, in order to secure a sufficient current blocking effect and flatness of the portion on the waveguide, the amount of growth of InP at the time of embedding growth is adjusted such that the waveguide 32 having the mesa structure is completely embedded and that semi-insulating InP has substantially the same height as the waveguide 32 having the mesa structure in a cross section of the waveguide. In this step, the InP film thickness is reduced at the waveguide terminal end 32e in the normal window region, which affects a light field (see Figs. 10(c) and 10(d)). However, in the present disclosure, the waveguide terminal end 32e is arranged outside the chip (in an adjacent chip), and thus the waveguide terminal end does not affect light propagating through the chip.

Subsequently, the insulating layer mask 85 is removed, and then, in order to electrically separate the regions of the DFB laser 11, the EA modulator 12, and the SOA 16, contact layers between the regions are removed by wet etching. Next, a P-side electrode for injecting a current through the contact layer on each region of an upper surface of the semiconductor substrate is formed. Thereafter, the InP substrate 81 is polished to approximately 150 µm, and an electrode is formed on a back surface of the substrate. Thus, the step on the semiconductor wafer is completed.

Next, a semiconductor Bar including the plurality of chips 31 is fabricated by forming the (011) crystal plane by cleavage. Here, a general semiconductor chip cleavage step is used, and cleavage position accuracy thereof is ±10 µm or less as described above. The semiconductor Bar in which the plurality of chips fabricated by the cleavage step is connected in the Y direction is used, and AR coating is applied to the emitting end surface, and high reflection coating (HR) is applied to an end surface on the DFB laser 11 side.

In order to confirm effects of this example, 20 AXEL chips fabricated in the same step were mounted on modules and were evaluated. First, optical outputs of the AXEL chips before being mounted on the modules were evaluated by using a large-diameter PD. The evaluation was performed by setting input currents to the DFB laser 11 and the SOA 16 to 80 mA and 40 mA, respectively, and inputting an applied voltage of 0.6 V and a 25 Gbit/s electrical signal to the EA modulator 12. As a result, net optical outputs of the fabricated AXEL chips were approximately 12 dBm on average in modulated output Pavg. Next, optical outputs after the AXEL chips were mounted on the modules were evaluated. The module fabrication step was implemented in the above-described active alignment step. As a result, it was confirmed that the modulated optical output Pavg at the time of optical coupling exceeded 9 dBm in all the 20 modules. As in the evaluation shown in Fig. 15, all losses in the modules obtained by comparing optical output intensities before and after mounting on the modules were less than 2.5 dB, and a module manufacturing yield was significantly improved as compared with a conventional AXEL chip having no window region. If the conventional AXEL chip is mounted on a module, a loss of 3 dB or more is expected when being mounted on the module, and thus it is difficult to manufacture an optical transmitter that achieves a target optical output of +9 dBm. In the conventional AXEL chip, a yield at the time of modularization of chips manufactured in a wafer surface is approximately 40%, whereas, in the AXEL module according to this example, the module manufacturing yield was improved to 65%.

Next, a modulation characteristic at 25 Gbit/s was evaluated by using a module on which the AXEL chip of the present embodiment was mounted to confirm operation quality. Modulation signals NRZ and PRBS2³¹-1 were used. Driving conditions of the AXEL are the same as the above-described conditions. Here, EYE waveform quality at 25 Gbit/s was evaluated, and a dynamic extinction ratio of 9.1 dB on average was obtained. Further, as a result of calculating the mask margin from the EYE waveform, 30% or more was obtained in all the modules. In this example, the width of the narrow waveguide region was set to 0.5 µm, and the above results supported the results described with reference to Fig. 14. From those results, a stable mask margin > 30% was obtained in the optical transmitter including the module according to this example, regardless of the cleavage position shift, and this level is substantially the same as that of a module including the conventional AXEL chip having satisfactory quality. In the module on which the AXEL chip of this example was mounted, there was no deterioration or the like in waveform quality of an optical signal, and only the manufacturing yield was dramatically increased.

Finally, when the transmission characteristic of 40 km by a single mode fiber was evaluated by using the above-described operation condition, error-free transmission having a bit error rate below 10⁻¹² was confirmed. From the above results, in an AXEL having a dummy mesa structure in a window region, it was confirmed that the module manufacturing yield was dramatically improved without deteriorating conventional module performance.

### (Example 2)

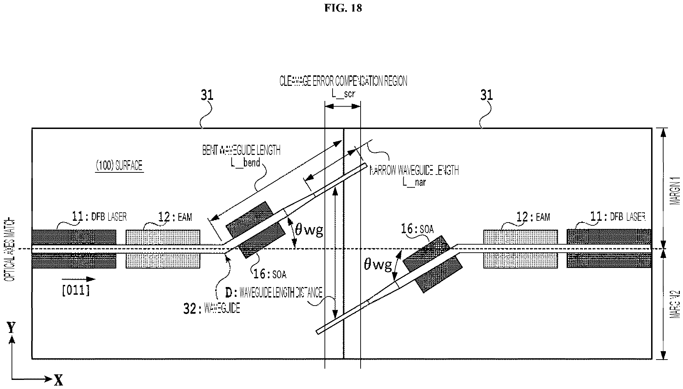

An AXEL of Example 2 will be described with reference to Fig. 18. In this example, a chip design capable of improving a production volume in the same wafer surface was adopted for an AXEL chip in a 1.5 µm band. Fig. 18 schematically illustrates an arrangement example of AXEL chips adopted in this example.

As described above with reference to Fig. 4, in a case where two AXWL chips (two semiconductor chips 31) facing each other on a wafer are arranged such that optical axes in the vicinity of an emitting portion match with each other (waveguides are continuously provided) as in the conventional AXELs, Y-direction positions of the DFB laser 11 including the waveguide 32 in the direction of the substrate crystal orientation [011] and the EA modulator 12 do not match with each other in the two AXELs, and a large offset occurs. From the viewpoint of securing a margin at the time of cleaving a chip side wall and an electrode having a sufficient area, the DFB laser 11 and the EA modulator 12 are desirably arranged at the center of the chip far from the chip side wall. Therefore, in such a chip arrangement, it is necessary to design a relatively large chip width. In a case where such the arrangement is adopted in a general AXEL chip, the chip width (length in the Y direction) needs to be at least approximately 300 µm.

Meanwhile, in the AXEL according to this example, as illustrated in Fig. 18, two facing AXEL chips are arranged on a wafer such that the optical axes of the bent waveguide portions 32b of the waveguides 32 do not match with each other and the optical axes of the linear waveguide portions 32a of the waveguides 32 match with each other. Therefore, the waveguide in the direction of the substrate crystal orientation [011] of the DFB laser 11 and the EA modulator 12 can be arranged near the center of the AXEL chip, and thus the chip width can be reduced.

The step of fabricating the AXEL chip according to this example is substantially the same as the above-described step of fabricating the AXEL chip according to Example 1. The lengths of the DFB laser 11, the EA modulator 12, and the SOA 16 in the AXEL chip are 350 µm, 200 µm, and 300 µm, respectively. The diffraction grating 14 (not illustrated) formed in the DFB laser 11 has a period designed to have the oscillation wavelength of 1.55 µm. The length L_bend of the bent waveguide portion, which includes the length of the SOA 16 which is 300 µm, is 500 µm, and a value of the angle θwg is 5°. Therefore, the waveguide offset ΔY is 44 µm, and the waveguide distance D is 88 µm. The two AXEL chips (two semiconductor chips 31) are separated by the cleavage step. As described above, the position shift error of approximately ±10 µm normally occurs in the cleavage step. In this example, as well as in Example 1, the length L_nar of the narrow waveguide is designed to be 30 µm, and the cleavage error compensation region L_scr of 20 µm or more is secured in consideration of the position shift error in the cleavage step. In this example, the chip width (length in the Y direction) is reduced to 200 µm, which is difficult in the conventional AXEL. This is because, as described above, the limitation on the chip size caused by the waveguide offset is relaxed by the present disclosure. In the AXEL chip according to this example, the linear waveguide portion is arranged at the center of the chip in the Y direction, and the margin 1 and the margin 2 of 100 µm are secured on both sides of the linear waveguide portion in the Y direction. Although the width of the conventional AXEL chip is limited to approximately 300 µm, the chip size is reduced according to the invention of this example. Therefore, the number of AXEL chips fabricable on the same wafer was successfully improved by 50%.

Subsequently, basic characteristics of the fabricated AXEL chips were evaluated. When currents of 80 mA and 100 mA were applied to the DFB laser 11 and the SOA 16, respectively, at an operation temperature of 55°C, and modulation using a 10 Gbit/s NRZ signal was performed at an applied voltage of -1.5 V and an amplitude voltage Vpp = 1.5 V in the EA modulator 12, a high output characteristic reaching 11 dBm at a maximum was confirmed as the modulated optical output. When a fabrication yield of the modules on which the AXEL chip of this example was mounted was evaluated, the module manufacturing yield of approximately 60%, which was an extremely satisfactory result, was confirmed in the AXEL chips having the narrow waveguide region according to this example with respect to a target value of the modulated optical output which was 10 dBm or more.

### (Example 3)

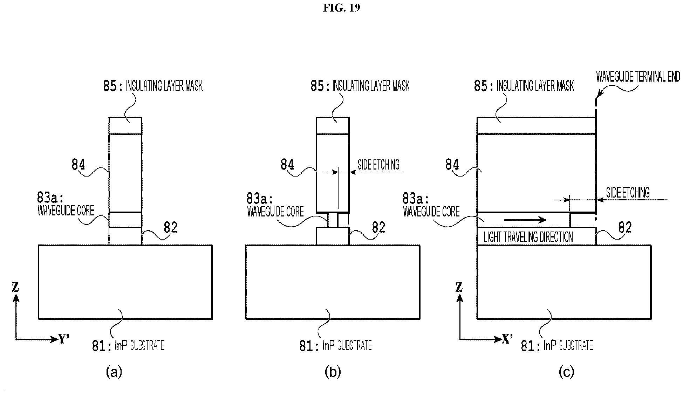

Example 3 will be described with reference to Figs. 19, 20, and 21. This example adopts a structure in which the width of the waveguide is enlarged near the terminal end in order to improve manufacturing stability of the window structure portion. First, a problem regarding the manufacturing stability to be solved by this example will be described. In the AXEL according to this example, the passive waveguide of the waveguide 32 terminates inside the chip. In the AXEL fabrication step, the passive waveguide collapses and disappears starting from the terminal end. The collapse and disappearance of the passive waveguide cause reduction in an AXEL manufacturing yield. This problem caused by the terminal end of the passive waveguide occurs more significantly in a narrow waveguide as used in the present disclosure in particular. A reason therefor will be described with reference to Fig. 19.

Fig. 19(a) is a cross-sectional view illustrating a mesa shape formed by dry etching in the AXEL fabrication step. The cross section of Fig. 19(a) is the mesa structure viewed from a Y' direction intersecting the Y direction at the angle θwg. Fig. 19(a) is the same as Fig. 9(b). In an actual AXEL fabrication step, a damaged layer of a mesa-shaped side wall generated by dry etching is removed before embedding regrowth, and wet etching processing of exposing a normal semiconductor surface to the side wall is performed.

Fig. 19(b) is a cross-sectional view illustrating the mesa shape subjected to the wet etching processing. As in Fig. 19(a), the cross section of Fig. 19(b) is the mesa structure viewed from the Y' direction intersecting the Y direction at the angle θwg. The wet etching processing is normally performed by using a plurality of etching solutions, and, as one solution thereof, a solution for selectively etching the core layer is generally used to perform the processing. Therefore, selective etching is simultaneously performed not only on the passive waveguide but also on the core layer of the DFB laser 11, the core layer (MQW 1) of the SOA 16, and the core layer (MQW 2) of the EA modulator 12. As a result, the damaged layer on the side wall of the mesa structure is removed particularly in a light emitting region of the DFB laser 11, which suppresses non-radiative recombination that does not contribute to oscillation at the time of current injection, improves light emission efficiency, and improves the optical output characteristic and long-term reliability. As illustrated in Fig. 19(b), also in the passive waveguide, the waveguide core 83a is selectively etched by this wet etching step. As a result, side etching proceeds from both sides of the waveguide core 83a, and a core width (length in the Y' direction) is narrower than a width W1 of an upper portion of the mesa structure. In a case where a waveguide having a width narrower than usual is adopted as in the present disclosure, the width of the waveguide core 83a remaining after the wet etching processing is further narrowed. Therefore, in the AXEL fabrication step, abnormality of the waveguide tends to occur. Fig. 19(c) illustrates a cross section of the waveguide terminal end near the end surface. Fig. 19(c) illustrates the mesa structure viewed from a light traveling direction (X' direction orthogonal to Y'). The above-described side etching proceeds in the same manner also at the waveguide terminal end. Therefore, an effect of the etching solution proceeds from three directions, i.e., from both sides and a terminal end surface of the waveguide, near the waveguide terminal end, and thus the side etching easily proceeds. Therefore, the position of the waveguide core 83a is greatly retracted in the direction of the SOA 16 from an original waveguide terminal end position. In particular, in a case where the waveguide having the width narrower than usual is adopted as in the present disclosure, this phenomenon remarkably appears. The mesa structure waveguide is broken and disappears starting from the waveguide terminal end at which the position of the terminal end of the waveguide core 83a is retracted. The breakage and disappearance of the mesa structure waveguide reduces the AXEL chip manufacturing yield. In order to fundamentally prevent the breakage and disappearance of the waveguide, there is a method of reducing a time of the wet etching processing before embedding regrowth. However, the wet etching processing is an essential step for securing high output and high reliability of the above-described DFB laser portion, and thus it is difficult to solve the problem only by adjusting fabrication conditions.

In view of this, this example adopts a structure in which the narrow width of the narrow waveguide at the cleavage position 34 of the AXEL chip is converted into a thick width again in the tapered region provided near the waveguide terminal end. This structure can be stably manufactured while suppressing the breakage and disappearance of the waveguide caused by side etching at the time of the wet etching processing.

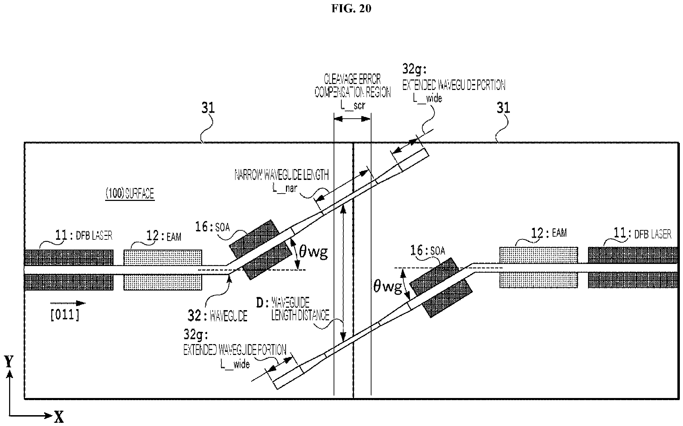

Fig. 20 illustrates a schematic configuration of the AXEL chips according to this example. This example can improve the yield of the AXEL chips having a broadband characteristic in which high-speed modulation of 50 Gbaud class can be performed and a high output characteristic of 10 dBm or more. However, improvement in the manufacturing yield, which is an effect of this example, does not depend on an operation speed or the optical output characteristic of the AXEL chips and can be introduced into AXEL chips of various specifications. As described above, a width W2 of the waveguide 32 near the cleavage position 34 is narrowed to obtain a sufficient reflection suppression effect. Therefore, the reflection suppression effect similar to that of Example 1 described above can be expected. The width of the waveguide 32 is narrowed by using the tapered region, and the width of the waveguide is gradually increased in a light guiding direction. The AXEL chip 31 of this example forming the optical transmitter is a semiconductor chip in which the DFB laser 11 having the length of 300 µm, the EA modulator 12 having the length of 125 µm, and the SOA having the length of 150 µm are monolithically integrated. The waveguide 32 adopts a buried heterostructure using semi-insulating InP capable of obtaining a high heat dissipation effect and a current blocking effect.

In this example, the quantum well structure of the EA modulator 12 and the length of the EA modulator 12 are optimized to support a high-speed modulation operation of 50 Gbaud. As described above, in the AXEL chip of this example, the tapered region 32c and the narrow waveguide region 32d are provided in the bent waveguide portion 32b in order to obtain a sufficient reflection suppression effect. The narrow waveguide region 32d is positioned in the vicinity of the emitting end surface. The AXEL chip is formed on the InP substrate (100) surface, and the DFB laser 11 is arranged to output light in the direction of the substrate orientation [011]. Light from the DFB laser 11 passes through the EA modulator 12 having the same optical axis as the DFB laser 11, then changes its propagation direction in the bent waveguide portion so as to have the angle θwg with respect to the direction of the crystal orientation [011], and is incident on the SOA 16. The light emitted from the SOA 16 is converted into the width W2 of the narrow waveguide in the tapered region while maintaining the angle θwg and passes through the position 44 to be cleaved, and then the width is increased along the light propagation direction by another tapered region arranged in the adjacent chip and is converted into a waveguide having a width W3, thereby reaching a waveguide terminal end of an extended waveguide portion 32g. Here, the angle θwg is set to 5° as the bending angle at which a sufficient reflection suppression effect can be obtained. Further, in order to obtain a sufficient reflection suppression effect, the width W2 of the narrow waveguide region is set to 0.5 µm which is a range in which stable manufacturing can be performed in the semiconductor processing process.

Under this condition, the narrow waveguide region does not satisfy the cut-off condition. Therefore, the light propagates through the narrow waveguide region without being radiated. Further, the two AXEL chips adjacent in the X direction face each other. In the two AXEL chips, the linear waveguide portions in each of which the DFB laser 11 and the EA modulator 12 are formed are arranged in parallel so as to have the matched optical axes. The bent waveguide portions of the two AXEL chips are arranged in parallel and are apart by the distance D on the position to be cleaved. Here, the length L_bend of the bent waveguide portion of the AXEL chip is 400 µm. Therefore, the waveguide distance D is 70 µm. The two AXEL chips are separated by the cleavage step. As described above, the position shift error of approximately ±10 µm normally occurs in the cleavage step. Therefore, a final light emitting position of the chip is determined when the cleavage step is completed.

It is necessary to secure 5 µm or more as the length of the narrow waveguide region following the tapered region in the AXEL chip (M2 in Fig. 13). In consideration of the position shift error in the cleavage step, it is necessary to secure 20 µm or more as the cleavage error compensation region L_scr (M1 in Fig. 13) and to secure 5 µm or more as the length of the remaining waveguide in the adjacent AXEL chip (M3 in Fig. 13). Therefore, in this example, the narrow waveguide is designed to have the length L_nar of 30 µm. When the position shift in the cleavage step is zero, the narrow waveguide portion of 15 µm remains in the AXEL chip. Even in a case where the cleavage position shift occurs and the narrow waveguide region is reduced, the narrow waveguide region of 5 µm or more remains in the chip as long as the cleavage error falls within the range of ±10 µm. Meanwhile, even in a case where the narrow waveguide region is increased due to the cleavage position shift, the length of the narrow waveguide region in the chip is 25 µm or less, and the length of the remaining waveguide remaining in the facing AXEL chip is always 5 µm or more.

The extended waveguide portion 32g of the waveguide 32 is provided at a position sufficiently away from the position to be cleaved, which does not affect light propagating through the AXEL chip. A size of the extended waveguide portion 32g is set to have the length L_wide of 5 µm and the width W3 of 4 µm. For L_wide and W3, it is unnecessary to consider optical characteristics at the time of design because light does not propagate. Only from the viewpoint of the manufacturing stability of the AXEL chip, the mesa structure in which side etching by the wet etching processing hardly proceeds and which hardly collapses and disappears in the processing process is adopted. The structure of the waveguide terminal end according to this example can be changed by changing the insulating layer mask 85 (Fig. 19) at the time of mesa formation, and an additional fabrication step and an introduction load of a cost increase are hardly required.

In this trial product, in order to compare the effects, the waveguide terminal end having a narrow width (W3 = W2 = 0.5 µm) and the waveguide terminal end having a wide width (W3 = 4 µm) were fabricated in the same lot and the same step and were compared. First, an amount of side etching after the wet etching processing was compared in a mesa processing process at the time of the fabrication step. In a normal fabrication step, side etching of approximately 0.25 µm on one side proceeds in a waveguide cross-sectional direction (Fig. 19(b)). Therefore, in order to achieve the waveguide width W2 = 0.5 µm, the mesa width at the time of the dry etching processing for mesa formation needs to be 1.0 µm. In a case where the waveguide terminal end is the waveguide having the narrow width, the amount of side etching in the cross section of the terminal end with respect to the light traveling direction was confirmed to be 0.6 µm. Because etching proceeds from the three directions at the waveguide terminal end, there is a high possibility that side etching deeply enters to cause collapse and disappearance of the waveguide core. Meanwhile, in a case where the width W3 of the waveguide was increased to 4 µm, the amount of side etching in the cross section of the terminal end with respect to the light traveling direction was reduced to 0.3 µm. Because the width W3 of the waveguide was increased, the amount of side etching at the waveguide terminal end was reduced, and, in addition, the region of the remaining waveguide core 83a was increased. This achieves a physically stable structure. Therefore, breakage of the waveguide starting from the waveguide terminal end hardly occurs.

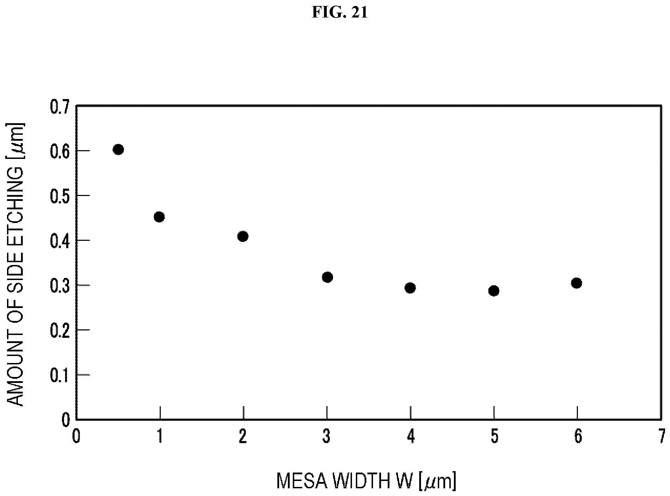

Fig. 21 shows results of examining a relationship between the width W3 of the waveguide terminal end and the amount of side etching in a sample fabricated on the same wafer. In this example, the width W3 of the waveguide terminal end portion is 4 µm, but, according to Fig. 21, it was confirmed that the amount of side etching was sufficiently suppressed when the width W3 of the waveguide terminal end portion was 3 µm or more.

Next, the actual AXEL fabrication step was completed, then an external appearance inspection of the AXEL chips fabricated on the same wafer was performed, and the chip yield was compared. Here, a normal appearance inspection was performed, and a proportion of failed chips caused by breakage of the waveguide starting from the waveguide terminal end was compared. As a result, it was confirmed that, in the AXEL chip (the width W3 of the waveguide terminal end = 4 µm) according to this example, a failed chip yield caused by breakage of the waveguide was improved by approximately 15%, as compared with the AXEL chip (the width W3 of the waveguide terminal end = W2 = 0.5 µm) according to Example 1.

Subsequently, basic characteristics of the fabricated AXEL chips were evaluated. When currents of 60 mA and 100 mA were applied to the DFB laser 11 and the SOA 16, respectively, at the operation temperature of 55°C, and modulation using a 50 Gbit/s NRZ signal was performed at the applied voltage of -1.5 V and the amplitude voltage Vpp = 1.5 V in the EA modulator 12, a high output characteristic reaching 10.5 dBm at a maximum was confirmed as the modulated optical output. Even in a case where the width of the waveguide terminal end was enlarged, the basic characteristics of the AXEL chips were not affected, and substantially the same degree of performance as the conventional one was confirmed.

### (Example 4)

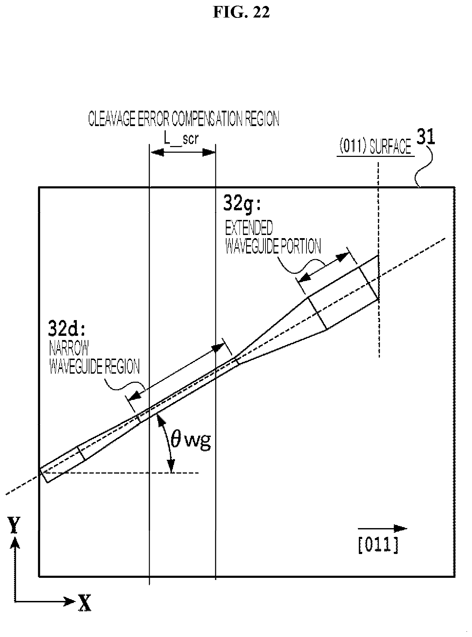

Example 4 will be described with reference to Fig. 22. In this example, when the crystal plane orientation at the waveguide terminal end was adjusted, the amount of side etching was suppressed, and the manufacturing stability was improved. As described above, the passive waveguide terminates inside the chip in the AXEL chip according to the present disclosure, and the collapse and disappearance of the waveguide starting from this terminal end portion in the process step reduces the yield. The collapse and disappearance of the waveguide occurs because side etching proceeds to the waveguide core 83a by the wet etching processing described with reference to Fig. 19(b). In particular, side etching remarkably proceeds at the terminal end portion of the waveguide.

In view of this, in this example, the width of the waveguide terminal end was extended as described in Example 3, and, in addition, the (011) crystal plane was used as a surface of the waveguide terminal end. A basic AXEL chip structure is the same as that of Example 3 described above, and the surface of waveguide terminal end was changed in this example.

Fig. 22 is a top view illustrating a schematic configuration of the waveguide terminal end and its vicinity in the AXEL chip according to this example. In order to obtain a sufficient reflection suppression effect, the narrow waveguide region 32d having the narrow width W2 is provided in the waveguide 32 near the cleavage position. Therefore, the reflection suppression effect similar to that of Example 1 or 3 can be expected. The tapered region is also provided in the waveguide 32, and the width of the waveguide is gradually changed to the narrow width W2 along the light traveling direction. The AXEL chip is formed on the InP substrate (100) surface, and the DFB laser 11 is arranged to output light in the direction of the substrate orientation [011]. Light from the DFB laser 11 passes through the EA modulator 12 having the same optical axis as the DFB laser 11, then changes its propagation direction in the bent waveguide portion so as to have the angle θwg with respect to the direction of the crystal orientation [011], and is incident on the SOA 16. The light emitted from the SOA 16 is converted into the width W2 of the narrow waveguide in the tapered region while maintaining the angle θwg and passes through the position 44 to be cleaved, and then the width is increased along the light propagation direction by another tapered region arranged in the adjacent chip and is converted into the waveguide having the width W3, thereby reaching the waveguide terminal end of the extended waveguide portion 32g. Here, a terminal end surface of the extended waveguide portion 32g of the waveguide 32 is one of side wall surfaces formed by dry etching, and the terminal end surface of the waveguide is normally formed as a surface perpendicular to the optical axis. Therefore, in a case where the waveguide itself forms the angle θwg with respect to the crystal orientation [011], the terminal end surface is a surface inclined by θwg from the crystal plane (011).

In this example, the terminal end surface of the extended waveguide portion 32g is not a surface perpendicular to the optical axis, but is a surface matching with the crystal orientation (011) plane. The terminal end surface of the extended waveguide portion 32g can be changed by changing the insulating layer mask 85 (Fig. 19) at the time of mesa formation, and an additional fabrication step and an introduction load of a cost increase are hardly required. The amount of side etching of the waveguide core 83a by the above-described wet etching depends on a plane orientation. That is, the amount of side etching on the (011) plane is the smallest, and the amount of side etching tends to increase as the angle formed with respect to the (011) plane increases. As described above, because side etching proceeds from the three directions, side etching is the most remarkable at the waveguide terminal end. In this example, the terminal end surface of the extended waveguide portion 32g corresponding to the terminal end surface of the waveguide is set to the (011) plane, and thus side etching of the waveguide core 83a is suppressed, and the collapse and disappearance of the waveguide during the fabrication step are prevented. This makes it possible to achieve stable manufacturing and improvement in the yield.

The AXEL chips according to this example were fabricated, and the basic characteristics were evaluated. The structure and fabrication step of the AXEL chips are the same as those of the AXEL chips in Example 3 except for the above-described structure of the waveguide terminal end. Also in the basic characteristics of the fabricated AXEL chips, the output and modulation characteristics substantially the same as those of the AXEL chips of Example 3 described above were confirmed. In addition, in the AXEL chips according to this example, a chip defect rate caused by abnormality of the waveguide terminal end portion was reduced by approximately 5%, as compared with the AXEL chips according to Example 3, and it was confirmed that there was a sufficient effect of improving the manufacturing yield.

### Industrial Applicability

It is possible to improve manufacturing stability and a reflection suppression effect of an optical transmitter.

### Reference Signs List

- 10: EADFB laser
- 11: DFB laser
- 12: EA modulator
- 13: Active layer
- 14: Diffraction grating
- 15: Absorbing layer
- 16: SOA
- 20: AXEL
- 31: Semiconductor chip
- 32: Waveguide
- 32a: Linear waveguide portion
- 32b: Bent waveguide portion
- 32c: Tapered region
- 32d: Narrow waveguide region
- 32e: Waveguide terminal end
- 32f: Remaining waveguide
- 32g: Extended waveguide portion
- 33: Emitting end surface
- 34: Cleavage position
- 35: Window region
- 44: Position to be cleaved
- 81: InP substrate
- 82: Lower cladding layer
- 83: Core layer
- 83a: Waveguide core
- 84: Upper cladding layer
- 85: Insulating layer mask
- 86: Current block (InP) layer

## Claims

1. An optical transmitter, comprising:
a distributed feedback (DFB) laser having an active region formed as a multiple quantum well that generates an optical gain by current injection and a diffraction grating;
an electro-absorption (EA) modulator having an absorption region formed as a multiple quantum well having a composition different from a composition of the DFB laser;
a semiconductor amplifier (SOA) having an active region having a same composition as the composition of the DFB laser;
a bent waveguide that rotates a light propagation direction by an angle θwg; and
a passive waveguide connected to the SOA and including a core having a band gap wavelength shorter than an oscillation wavelength of the DFB laser, and
wherein
the DFB laser, the EA modulator, the SOA, the bent waveguide, and the passive waveguide are monolithically integrated on one substrate,
the passive waveguide has a tapered region and a narrow waveguide region,
the tapered region converts a width W1 of the passive waveguide connected to the SOA into a width W2 of the narrow waveguide region, where W1 > W2 is satisfied, and
the passive waveguide forms the angle θwg with respect to a normal line to an end surface of the substrate and is in contact with the end surface of the substrate.

2. The optical transmitter according to claim 1, further comprising
a second passive waveguide, wherein
the second passive waveguide
is located at a position separated from the passive waveguide by a distance D,
includes a core having a same composition as a composition of the passive waveguide,
is in contact with the end surface of the substrate at the angle θwg with respect to the normal line to the end surface of the substrate,
terminates in the substrate,
has the width W2, and
has a length L_d.

3. The optical transmitter according to claim 2, wherein
the substrate is an InP substrate,
the DFB laser, the EA modulator, and the SOA are formed on a (100) surface of the InP substrate,
the DFB laser has an optical axis in a direction of a substrate crystal orientation [011], and
the passive waveguide forms an angle θw with respect to the substrate crystal orientation [011] and is in contact with the end surface of the substrate.

4. The optical transmitter according to claim 3, wherein
the second passive waveguide has
the width W2 at a position in contact with the end surface of the substrate, and
has an extended waveguide portion at a terminal end,
the extended waveguide portion has a width W3, and
W2 < W3 is satisfied.

5. The optical transmitter according to claim 4, wherein W3 > 3 µm is satisfied.

6. The optical transmitter according to claim 5, wherein a terminal end surface of the extended waveguide portion matches with a substrate crystal plane (011).

7. The optical transmitter according to claim 2, wherein 5 µm < L_d < 25 µm is satisfied.

8. The optical transmitter according to claim 1, wherein 0.4 µm < W2 < 0.8 µm is satisfied.

9. The optical transmitter according to claim 1, wherein 4° < θwg < 8° is satisfied.

10. The optical transmitter according to claim 2, wherein 30 µm < D < 140 µm is satisfied.
